# EUROPÄISCHE PATENTSCHRIFT

(11) **EP 3 084 039 B1**
(45) Veröffentlichungstag und Bekanntmachung des Hinweises auf die Patenterteilung: **15.05.2019**
(21) Anmeldenummer: 14806299.5
(22) Anmeldetag: 04.12.2014
(51) Int. Cl.: C23C 18/14, C23C 18/04, C23C 18/08

(54) **VERFAHREN ZUR HERSTELLUNG STRUKTURIERTER METALLISCHER BESCHICHTUNGEN**
METHOD FOR PRODUCING PATTERNED METALLIC COATINGS
PROCÉDÉ DE FABRICATION DE REVÊTEMENTS MÉTALLIQUES STRUCTURÉS

(30) Priorität: 19.12.2013 DE 102013114572
(43) Veröffentlichungstag der Anmeldung: 26.10.2016
(73) Patentinhaber: Leibniz-Institut für Neue Materialien gemeinnützige GmbH, 66123 Saarbrücken (DE)
(72) Erfinder: DE OLIVEIRA, Peter William, 66123 Saarbrücken (DE); DÖRR, Tobias, 66589 Merchweiler (DE); MOH, Karsten, 66440 Blieskastel-Brenschelbach (DE)
(74) Vertreter: Patentanwälte Gierlich & Pischitzis Partnerschaft mbB
(86) Internationale Anmeldenummer: PCT/EP2014/076522
(87) Internationale Veröffentlichungsnummer: WO 2015/090991

(56) Entgegenhaltungen:
- EP-A1- 1 553 212
- WO-A2-2013/068853
- US-A1- 2006 122 297
- US-A1- 2011 003 141
- US-A1- 2011 124 252
- US-A1- 2011 143 051

## Beschreibung

### Gebiet der Erfindung

Die Erfindung betrifft ein Verfahren zur Herstellung von strukturierten metallischen Beschichtungen, welche bevorzugt transparent sind.

### Stand der Technik

Strukturierte leitfähige Beschichtungen spielen bei vielen Anwendungen eine wichtige Rolle. Insbesondere bei Touchscreens oder OLEDs werden solche strukturierten leitfähigen Beschichtungen benötigt. Bevorzugt sind die Beschichtungen auch noch transparent.

Ein Problem dabei ist, dass die Substrate der vorgenannten Anwendungen meistens aus Kunststoff sind. Solche Kunststoffe sind nicht nur Isolatoren, sondern erfordern auch geringe Temperaturen bei der Behandlung ihrer Oberflächen.

Insbesondere transparente Beschichtungen erfordern besonders feine Strukturen. Diese sind durch Druckverfahren kaum zu erhalten. Auch ist das Beschichten von größeren Flächen problematisch.

Aus dem Dokument WO 2012/084849 A2 sind Emulsionen mit Silbernanopartikeln bekannt, welche auf Oberflächen leitfähige Strukturen ausbilden. Dabei bilden die Silbernanopartikel nach einem Sinterprozess die leitfähigen Strukturen. Nachteilig ist dabei, dass gerade die Leitfähigkeit sehr schlecht kontrolliert werden kann und die Herstellung der Strukturen einen Sinterprozess bei erhöhten Temperaturen erfordert.

US 2011/003141 A1 offenbart die Herstellung von leitfähigen Gittern durch Aufbringen von metallischen Partikeln und anschließender Abscheidung von Metallen.

EP 1 553 212 A1 offenbart die Herstellung von Linien auf einer Oberfläche durch Belichtung eine Silberhalogenidemulsion.

US 2011/143051 A1 beschreibt eine leitfähige Tinte, welche einen leitfähigen dünnen Film aus metallischen Nanopartikeln durch chemische Reduktion erzeugen kann.

US 2006/122297 A1 offenbart eine Dispersion aus photokatalytischen Pigmenten und Metallsalzen durch deren Belichtung eine metallische Schicht erzeugt wird.

### Aufgabe

Aufgabe der Erfindung ist es, ein Verfahren zur Beschichtung von Oberflächen mit leitfähigen Beschichtungen bereitzustellen, welches bei niedrigen Temperaturen durchführbar ist und welches außerdem eine gute Kontrolle über die Strukturen ermöglicht.

### Lösung

Diese Aufgabe wird durch die Erfindungen mit den Merkmalen des unabhängigen Anspruchs gelöst. Vorteilhafte Weiterbildungen der Erfindungen sind in den Unteransprüchen gekennzeichnet. Die Erfindungen umfassen auch alle erwähnten Kombinationen von abhängigen Ansprüchen.

Die Aufgabe wird durch ein Verfahren zur Herstellung von strukturierten metallischen Beschichtungen umfassend die folgenden Schritte gelöst:
a) Auftragen einer Initiatorzusammensetzung auf einem Substrat umfassend mindestens eine aktive Substanz, wobei die Zusammensetzung eine Emulsion ist und die aktive Substanz nanoskalige Partikel (1) aus ZnO oder TiO₂ ist;
b) Auftragen einer Vorläuferzusammensetzung auf das Substrat umfassend mindestens eine Vorläuferverbindung für eine Metallschicht;
c) Abscheidung einer Metallschicht aus der Vorläuferzusammensetzung durch die aktive Substanz der Initiatorzusammensetzung durch photochemische Aktivierung;
wobei zwischen Schritt a) und Schritt b) eine Trocknung durchgeführt wird, was zu einer Konzentration der Nanopartikel an den Phasengrenzflächen der Emulsion auf der Oberfläche führt.

Im Folgenden werden einzelne Verfahrensschritte näher beschrieben. Das zu schildernde Verfahren kann auch weitere, nicht genannte Schritte aufweisen.

Das Substrat, das mit der Initiatorzusammensetzung beschichtet werden soll, kann jedes für diesen Zweck geeignete Material sein. Beispiele für geeignete Materialien sind Metalle oder Metalllegierungen, Glas, Keramik, einschließlich Oxidkeramik, Glaskeramik oder Kunststoffe, sowie Papier und andere zellulosehaltige Materialien. Selbstverständlich sind auch Substrate verwendbar, die eine Oberflächenschicht aus den vorstehend genannten Materialien aufweisen. Bei der Oberflächenschicht kann es sich z.B. um eine Metallisierung, eine Emaillierung, eine Glas- oder Keramikschicht oder eine Lackierung handeln.

Beispiele für Metalle oder Metalllegierungen sind Stahl, einschließlich Edelstahl, Chrom, Kupfer, Titan, Zinn, Zink, Messing und Aluminium. Beispiele für Glas sind Natronkalkglas, Borosilikatglas, Bleikristall und Kieselglas. Es kann sich z.B. um Flachglas, Hohlglas wie Behälterglas, oder um Laborgeräteglas handeln. Bei der Keramik handelt es sich z.B. um eine Keramik auf Basis der Oxide SiO₂, Al₂O₃, ZrO₂ oder MgO oder der entsprechenden Mischoxide. Beispiele für den Kunststoff, der, wie auch das Metall, als Folie vorliegen kann, sind Polyethylen (PE), z.B. HDPE oder LDPE, Polypropylen, Polyisobutylen, Polystyrol (PS), Polyvinylchlorid (PVC), Polyvinylidenchlorid, Polyvinylbutyral, Polytetrafluorethylen, Polychlortrifluorethylen, Polyacrylate, Polymethacrylate wie Polymethylmethacrylat (PMMA), Polyamid, Polyethylenterephthalat, Polycarbonat, regenerierte Cellulose, Cellulosenitrat, Celluloseacetat, Cellulosetriacetat (TAC), Celluloseacetatbutyrat oder Kautschuk-Hydrochlorid. Eine lackierte Oberfläche kann aus üblichen Grundanstrichen oder Lacken gebildet sein. In einer bevorzugten Ausführungsform sind die Substrate Folien, insbesondere Polyethylenterephthalatfolien oder Polyimidfolien.

Mindestens die Initiatorzusammensetzung ist erfindungsgemäß eine Emulsion. Die aktive Substanz sowie ggf. die Vorläuferverbindung sind dann bevorzugt in einer der Phasen, besonders bevorzugt an den Phasengrenzflächen, angeordnet. Dies resultiert häufig schon daraus, dass die aktive Substanz sowie ggf. die Vorläuferverbindung eine unterschiedliche Verteilung innerhalb der Phasen der Emulsion aufweisen, z.B. weil sie hydrophob oder hydrophil sind. Dies führt dazu, dass beim Aufbringen auf einer Oberfläche die Strukturierung der Emulsion auf die Oberfläche übertragen wird. Auf der Oberfläche kommt es zu einer Selbstorganisation der Emulsion. Auf diese Weise kann eine netzartige oder wabenartige Struktur erhalten werden.

Bevorzugt handelt es sich bei der Emulsion um eine Pickering-Emulsion, d.h. eine Emulsion, welche durch die Zugabe von Partikeln stabilisiert wird. Bei solchen Emulsionen lagern sich die Partikel, insbesondere Nanopartikel, um die disperse Phase der Emulsion an, und stabilisieren dabei die Emulsion. Wie hoch die Stabilisierung ist, hängt zum einen vom Radius der Partikel, der Grenzflächenspannung, aber auch von ihrer Benetzbarkeit ab. Eine optimale Stabilisierung einer Öl/Wasser-Emulsion wird üblicherweise bei einem Kontaktwinkel von 90 °C erreicht. Die Teilchen dürfen daher auch nicht zu hydrophob oder hydrophil sein.

Gerade bei Pickering-Emulsionen führt das Aufbringen auf einer Oberfläche zu einer Selbstorganisation der Partikel entlang der Phasengrenzflächen. Dies führt dazu, dass eine netzartige oder wabenartige Struktur erhalten wird, welche aus den in der Emulsion vorhandenen Nanopartikeln besteht.

Die Emulsion kann dabei auch Dispersionsmittel zur Stabilisierung enthalten. Es kann sich um eine O/W- oder eine W/O-Emulsion handeln. Bevorzugt ist eine O/W-Emulsion. Dabei ist die hydrophobe Phase die disperse Phase. Im Falle einer Pickering-Emulsion stabilisieren die in der Emulsion enthaltenen Nanopartikel die disperse Phase der Emulsion.

Eine verwendete Emulsion besteht bevorzugt aus einer wässrigen und einer öligen Phase. Für die wässrige Phase sind Wasser oder Mischungen enthaltend Wasser und organische, vorzugsweise wasserlösliche Lösungsmittel bevorzugt. Besonders bevorzugt handelt es sich bei der wässrigen Phase um Wasser oder Mischungen von Wasser und Alkoholen, Aldehyden und/oder Ketonen, besonders bevorzugt um Wasser oder Mischungen aus Wasser mit ein- oder mehrwertigen Alkoholen mit bis zu vier Kohlenstoffatomen, wie z. B. Methanol, Ethanol, n-Propanol, iso-Propanol oder Ethylenglykol, Aldehyden mit bis zu vier Kohlenstoffatomen, wie z. B. Formaldehyd, und/oder Ketonen mit bis zu vier Kohlenstoffatomen, wie z. B. Aceton oder Methylethylketon. Ganz besonders bevorzugt ist die wässrige Phase Wasser.

Die Ölphase ist bevorzugt mindestens ein organisches Lösungsmittel, welches nicht in der wässrigen Phase löslich ist. Bevorzugt sind dies aromatische oder aliphatische Kohlenwasserstoffe mit mindestens 5 Kohlenstoffatomen, wie Petrolether, Hexan, Heptan, Toluol, Benzol, Cyclopentan oder Cyclohexan, halogenierte aromatische oder aliphatische Kohlenwasserstoffe wie Dichlormetan, Dichlormethan, Chloroform, Alkylacetate wie Butylacetat, Ketone wie Acetophenon oder Cyclohexanon. Es können auch Gemische der Lösungsmittel verwendet werden.

Bevorzugt sind für beide Phasen der Emulsion Lösungsmittel mit einem Siedepunkt von unter 150 °C.

Für eine Emulsion liegt der Anteil der Ölphase bevorzugt zwischen 15 Gew.-% und 80 Gew.-% bezogen auf die gesamte Zusammensetzung. Dabei führt ein Gehalt von >50 Gew.-% üblicherweise zu einer W/O-Emulsion, während ein Gehalt von <50 Gew.-% zu einer O/W-Emulsion führt.

Besonders bevorzugt sind Emulsionen mit einem Gehalt zwischen 15 Gew.-% und 40 Gew.-% an Ölphase bezogen auf die gesamte Zuammensetzung, bevorzugt zwischen 20 Gew.-% und 30 Gew.-% im Falle eine O/W-Emulsion und zwischen 60 Gew.-% und 80 Gew.-% im Falle einer W/O-Emulsion.

Die Emulsionen, wie auch die Zusammensetzungen, können noch weitere Verbindungen, wie beispielsweise Polymere, Puffer oder Dispergierhilfsmittel, Filmbildner etc. enthalten. Bevorzugt enthalten die Zusammensetzungen diese Hilfsmittel in einer Menge von nicht mehr als 10 Gew.-%, bevorzugt nicht mehr als 5 Gew.-% bezogen auf die gesamte Zusammensetzung.

In einer bevorzugten Ausführungsform der Erfindung umfasst die Emulsion keine Additive, insbesondere keine oberflächenaktiven Verbindungen, Bindemittel, Polymere, Puffer oder Dispergiermittel.

Die Initiatorzusammensetzung umfasst als Initiator mindestens eine aktive Substanz, welche eine Abscheidung einer Metallschicht aus der Vorläuferverbindung hervorrufen kann. Dies können - in Abhängigkeit von Aktivierung der Abscheidung - unterschiedliche Verbindungen sein. So kann die Abscheidung durch Bestrahlung hervorgerufen werden.

Erfindungsgemäß umfasst die Initiatorzusammensetzung als Initiator eine photokatalytisch aktive anorganische Substanz. Dabei wird unter photokatalytisch aktiver Substanz eine Verbindung verstanden, welche die Reduktion eines Metallions in einem Metallkomplex zum Metall direkt und/oder durch oxidative Aktivierung des Metallkomplexes oder einer weiteren Substanz indirekt bewirkt, ohne dabei selbst zersetzt zu werden. Durch die bei der Oxidation entstehenden Produkte kommt es zu einer Zersetzung des Metallkomplexes und Reduktion des Metallions des Komplexes. Bei dem photokatalytischen Material handelt es sich um ZnO oder TiO₂, wobei TiO₂ bevorzugt ist. Besonders bevorzugt liegt das TiO₂ als Anatas vor.

Das TiO₂ kann auch als amorphes TiO₂ vorliegen. Erfindungsgemäß handelt es sich um nanoskalige Partikel aus TiO₂ oder ZnO. Es kann sich beispielsweise um nanoskalige Partikel aus TiO₂ handeln, welche einen durchschnittlichen Durchmesser von unter 200 nm aufweisen, bevorzugt einen durchschnittlichen Durchmesser von unter 50 nm, besonders bevorzugt von unter 20 nm (bestimmt mittels TEM). Besonders bevorzugt sind Partikel mit einem durchschnittlichen Durchmesser (bestimmt mittels TEM) zwischen 1 bis 100 nm, bevorzugt zwischen 1 bis 20 nm.

In einer Weiterbildung der Erfindung liegt der hydrodynamische Radius der eingesetzten Partikel (gemessen mit DLS) unter 300 nm, bevorzugt unter 200 nm, besonders bevorzugt unter 150 nm. In einer ganz besonders bevorzugten Ausführungsform der Erfindung liegt der hydrodynamische Radius der Partikel unter 120 nm. Die Partikel können dabei auch als Aggregate mit den genannten hydrodynamischen Radien vorliegen. Die Partikel können dabei als Verteilung von Partikeln vorliegen, von denen mindestens 90 % hydrodynamische Radien innerhalb der vorstehend angegebenen Grenzen aufweisen.

In einer Weiterbildung der Erfindung weisen die Partikel unabhängig oder in Kombination mit den vorstehenden Größenangaben einen d₅₀-Wert von weniger als 100 nm, gemessen mittel dynamischer Lichtstreuung auf. Bevorzugt weisen die Partikel einen d₈₀-Wert von unter 150 nm auf.

Der hydrodynamische Radius kann durch eine Oberflächenmodifikation der Partikel zunehmen. In einer Weiterbildung der Erfindung sind im Fall von unmodifizierten Partikeln, Partikel mit einem d₅₀-Wert von unter 50 nm, bevorzugt mit einem d₈₀-Wert von unter 50 nm, bevorzugt. Im Fall einer Oberflächenmodifikation sind Partikel mit einem d₅₀-Wert von unter 100 nm, bevorzugt mit einem d₈₀-Wert von unter 150 nm, bevorzugt (alles gemessen mittels dynamischer Lichtstreuung).

Die eingesetzten Partikel liegen bevorzugt kolloidal stabil vor. Gegebenenfalls - aber nicht bevorzugt - können noch Stabilisierungshilfsmittel zugegeben werden.

Gerade bei der Verwendung einer photokatalytisch aktiven Initiatorzusammensetzung, bevorzugt mit TiO₂-Partikeln, ist es möglich, dass unter den Bedingungen der Belichtung auf der Oberfläche der Partikel befindliche eventuelle organische Bestandteile abgebaut werden. Wenn direkt metallische Partikel aufgebracht werden, können solche organischen Bestandteile die Leitfähigkeit massiv stören. Das erfindungsgemäße Verfahren ist durch solche Additive deutlich weniger beeinflussbar. Dadurch kann die Strukturierung auf der Oberfläche viel genauer gesteuert werden.

Besonders bevorzugt sind Partikel, welche mit einer unterstöchiometrischen Menge an Wasser unter hydrothermalen Bedingungen erhalten werden, wie beispielsweise in US 2009/0269510 A1 beschrieben. Solche Partikel können auch dotiert hergestellt werden.

Dazu kann bei den Nanopartikeln bei ihrer Herstellung eine geeignete Metallverbindung zur Dotierung eingesetzt werden, z.B. ein Oxid, ein Salz oder eine Komplexverbindung, z.B. Halogenide, Nitrate, Sulfate, Carboxylate (z.B. Acetate) oder Acetylacetonate. Die Verbindung sollte in dem für die Herstellung der Nanopartikel verwendeten Lösungsmittel zweckmäßigerweise löslich sein. Als Metall eignet sich jedes Metall, insbesondere ein Metall ausgewählt aus der 5. bis 14. Gruppe des Periodensystems der Elemente und der Lanthanoiden und Actiniden. Die Gruppen werden hier entsprechend dem neuen IUPAC-System aufgeführt, wie es in Römpp Chemie Lexikon, 9. Auflage, wiedergegeben ist. Das Metall kann in der Verbindung in jeder geeigneten Oxidationsvorstufe vorkommen.

Beispiele für geeignete Metalle für die Metallverbindung sind W, Mo, Zn, Cu, Ag, Au, Sn, In, Fe, Co, Ni, Mn, Ru, V, Nb, Ir, Rh, Os, Pd und Pt. Metallverbindungen von W(VI), Mo(VI), Zn(II), Cu(II), Au(III), Sn(IV), In(III), Fe(III), Co(II), V(V) und Pt(IV) werden bevorzugt verwendet. Sehr gute Ergebnisse werden insbesondere mit W(VI), Mo(VI), Zn(II), Cu(II), Sn(IV), In(III) und Fe(III) erreicht. Konkrete Beispiele für bevorzugte Metallverbindungen sind WO₃, MoO₃, FeCl₃, Silberacetat, Zinkchlorid, Kupfer(II)-chlorid, Indium(III)-oxid und Zinn(IV)-acetat.

Das Mengenverhältnis zwischen der Metallverbindung und der Titan- oder Zinkverbindung hängt auch von dem eingesetzten Metall und dessen Oxidationsstufe ab. Im Allgemeinen werden z.B. solche Mengenverhältnisse eingesetzt, dass sich ein Molverhältnis von Metall der Metallverbindung zu Titan/Zink der Titan- oder Zinkverbindung (Me/Ti(Zn)) von 0,0005:1 bis 0,2:1, bevorzugt 0,001:1 bis 0,1:1 und bevorzugter 0,005:1 bis 0,1:1 ergibt.

Die Dotierung von Nanopartikeln ist in US 2009/0269510 A1 beschrieben, deren Inhalt hiermit zum Gegenstand der Beschreibung gemacht wird. Im Wesentlichen wird auch dort eine vorstehend genannte Metallverbindung während der Herstellung zugegeben.

Die erfindungsgemäß verwendeten Nanopartikel können auch oberflächenmodifiziert werden, beispielsweise um ihnen eine Kompatibilität der Zusammensetzung zu verleihen und auch ihre Verteilung innerhalb einer Emulsion oder ihre Eigenschaften zur Stabilisierung einer Emulsion zu beeinflussen. So kann beispielsweise der Kontaktwinkel und damit ihre Eigenschaft zur Stabilisierung der Emulsion beeinflusst werden.

So können die Nanopartikel mit hydrophoben, hydrophilen, oleophoben oder oleophilen Funktion oberflächenmodifiziert sein. Zur Erzielung hydrophober und/oder oleophober Eigenschaften können z.B. Funktionsgruppen eingeführt werden, die fluorierte Kohlenwasserstoffketten umfassen.

Derartige Funktionsgruppen können durch Umsetzung der Nanopartikel mit einem Oberflächenmodifizierungsmittel erhalten werden. Bei der Oberflächenmodifizierung von nanoskaligen Teilchen handelt es sich um ein bekanntes Verfahren, wie es von der Anmelderin z.B. in WO 93/21127 (DE 4212633) oder WO 96/31572 beschrieben wurde. Die Herstellung der oberflächenmodifizierten Nanopartikel kann prinzipiell auf zwei verschiedenen Wegen durchgeführt werden, nämlich zum einen durch Oberflächenmodifizierung von bereits hergestellten nanoskaligen Teilchen und zum anderen durch Herstellung dieser Teilchen unter Verwendung von Oberflächenmodifizierungsmitteln.

Die Oberflächenmodifizierung von fertigen Nanopartikeln kann einfach durch Mischen der Teilchen mit dem Oberflächenmodifizierungsmittel erfolgen. Die Umsetzung erfolgt gegebenenfalls in einem Lösungsmittel und, falls notwendig, durch mechanische oder thermische Energiezufuhr und/oder durch Katalysatorzugabe.

Als Oberflächenmodifizierungsmittel eignen sich Verbindungen, die zum einen über eine oder mehrere Gruppen verfügen, die mit auf der Oberfläche der Nanopartikel vorhandenen reaktionsfähigen Gruppen (wie beispielsweise OH-Gruppen) reagieren oder wechselwirken können. Die Oberflächenmodifizierungsmittel können z.B. kovalente, koordinative (Komplexbildung) und ionische (salzartige) Bindungen zur Oberfläche der Nanopartikel ausbilden, während unter den reinen Wechselwirkungen beispielhaft Dipol-Dipol-Wechselwirkungen, Wasserstoffbrückenbindungen und van der Waals-Wechselwirkungen zu nennen sind. Bevorzugt ist die Ausbildung von kovalenten Bindungen, ionischen Bindungen oder die Komplexierung, ganz besonders bevorzugt durch ionische Bindungen oder Komplexierung.

Die Oberflächenmodifizierungsmittel weisen in der Regel ein relativ niedriges Molekulargewicht auf. Beispielsweise kann das Molekulargewicht weniger als 1.500, insbesondere unter 1.000 und vorzugsweise unter 700 und besonders bevorzugt unter 500 betragen, aber auch ein höheres Molekulargewicht, z.B. bis zu 2.000 und mehr, ist möglich.

Für die Oberflächenmodifikation der Nanopartikel kommen anorganische und organische Säuren, Basen, Chelatbildner, Komplexbildner, wie β-Diketone, Proteine, die komplexbildende Strukturen aufweisen können, Aminosäuren oder Silane in Frage. Das Oberflächenmodifizierungsmittel kann in einer bevorzugten Ausführungsform ein Komplexbildner sein, der durch Komplexierung auf der Oberfläche der Teilchen die Modifizierung bildet. Konkrete Beispiele für Oberflächenmodifizierungsmittel sind gesättigte oder ungesättigte Mono- und Polycarbonsäuren, die entsprechenden Säureanhydride, Säurechloride, Ester und Säureamide, Aminosäuren, Proteine, Imine, Nitrile, Isonitrile, Epoxyverbindungen, Mono- und Polyamine, β-Dicarbonylverbindungen, wie β-Diketone, Oxime, Alkohole, Alkylhalogenide, Metall- oder Halbverbindungen, die über eine funktionelle Gruppe verfügen, die mit den Oberflächengruppen der Partikel reagieren kann, z.B. Silane mit hydrolysierbaren Gruppen mit mindestens einer nicht hydrolysierbaren Gruppe. Spezielle Verbindungen für Oberflächenmodifizierungsmittel sind z.B. in den oben genannten WO 93/21127 und WO 96/31572 genannt.

Besonders bevorzugte Oberflächenmodifizierungsmittel sind gesättigte oder ungesättigte Carbonsäuren, β-Dicarbonylverbindungen, Amine, Phosphonsäuren, Sulfonsäuren oder Silane.

Wie geschrieben, hat die Funktionsgruppe in einer bevorzugten Ausführungsform mindestens eine funktionelle Gruppe. Hierfür werden Oberflächenmodifizierungsmittel verwendet, die neben einer funktionellen Gruppe für die Anbindung an die Oberfläche der Teilchen mindestens eine weitere funktionelle Gruppe umfassen.

Beispiele für eine weitere funktionelle Gruppe für die Funktionsgruppe sind Hydroxy, Epoxid, Thiol, Amino, Carboxyl, Carbonsäureanhydrid, Sulfonsäuregruppen, Phosphonsäuregruppen, quaternäre Amingruppen oder Carbonyl. Im weiteren Sinne kann man hierzu auch fluorierte Kohlenwasserstoffgruppen zählen. Dementsprechend werden dafür bi-, tri- oder höherfunktionelle Oberflächenmodifizierungsmittel verwendet, wobei bevorzugt Carbonsäuren, β-Dicarbonylverbindungen, Amine, Phosphonsäuren, Sulfonsäuren oder Silane mit mindestens einer zusätzlichen Gruppe ausgewählt aus den oben genannten funktionellen Gruppen bevorzugt sind, wie Hydroxycarbonsäuren, Aminosäuren, Aminosulfonsäuren, Aminophosphonsäuren, funktionalisierte β-Dicarbonylverbindungen.

Durch die Oberflächenmodifizierung können auch Gruppen eingeführt werden, welche die Abscheidung von Metallen begünstigen. Dies können beispielsweise reduzierende Gruppen wie Aldehydgruppen sein.

Beispiele für bevorzugte Verbindungen, die zur Oberflächenmodifizierung verwendet werden, werden im Folgenden aufgeführt:
Beispiele für Carbonsäuren, die vorzugsweise 1 bis 24 Kohlenstoffatomen enthalten, sind gesättigte Monocarbonsäuren (z.B. Ameisensäure, Essigsäure, Propionsäure, Buttersäure, Pentansäure, Hexansäure, Caprinsäure, Stearinsäure, Phenylessigsäure, Benzoesäure,), gesättigte Polycarbonsäuren mit 2 oder mehr Carboxylgruppen (z.B. Oxalsäure, Malonsäure, Adipinsäure, Bernsteinsäure, Glutarsäure und Phthalsäure), ungesättigte Carbonsäuren (z.B. Acrylsäure, Methacrylsäure, Crotonsäure, Maleinsäure, Fumarsäure und Ölsäure), α-Hydroxycarbonsäuren oder α-Ketocarbonsäuren (z. B. Glycolsäure, Milchsäure, Weinsäure, Citronensäure, 2-Hydroxybutansäure, 2,3-Dihydroxypropansäure, 2-Hydroxypentansäure, 2-Hydroxyhexansäure, 2-Hydroxyheptansäure, 2-Hydroxyoctansäure, 2-Hydroxydecansäure, 2-Hydroxydodecansäure, 2-Hydroxytetradecansäure, 2-Hydroxyhexadecansäure, 2-Hydroxyoctadecansäure, Mandelsäure, 4-Hydroxymandelsäure, ·Apfelsäure, Erythrarsäure, Threarsäure, Glucarsäure, Galactarsäure, Mannarsäure, Gularsäure, 2-Hydroxy-2-methylbemsteinsäure, Gluconsäure, Brenztraubensäure, Glucuronsäure und Galacturonsäure), β-Hydroxycarbonsäuren (z. B. Salicylsäure, Acetylsalicylsäure), sowie Derivate der Carbonsäuren, wie Anhydride, Ester (vorzugsweise C₁-C₄-Alkylester, z.B. Methylmethacrylat) und Amide.

Beispiele für β -Dicarbonylverbindungen, die vorzugsweise 4 bis 12, bevorzugter 5 bis 8 Kohlenstoffatomen enthalten, sind Acetylaceton, 2,4-Hexandion, 3,5-Heptandion, Acetessigsäure und Acetessigsäure-C₁-C₄-alkylester; sowie funktionalisierte Dicarbonylverbindungen, wie Hexafluoracetylaceton und Acetoacetamid.

Weitere Beispiele sind Mono- und Polyamine, insbesondere solche der allgemeinen Formel R₃₋ₙNHₙ, worin n = 0, 1 oder 2 und die Reste R unabhängig voneinander Alkylgruppen mit 1 bis 12, insbesondere 1 bis 8 und besonders bevorzugt 1 bis 6 Kohlenstoffatomen darstellen (z.B. Methyl, Ethyl, n- und i-Propyl, Butyl oder Hexyl) und Ethylenpolyamine (z.B. Ethylendiamin, Diethylentriamin etc.); Sulfonsäuren, wie 2-Aminoethansulfonsäure und 3-Aminobenzolsulfonsäure, Phosphonsäuren, Aminosäuren; Imine; und Silane, wie z.B. die hydrolysierbaren Silane mit mindestens einer nicht hydrolysierbaren Gruppe), wobei solche mit einer funktionellen Gruppe am nicht hydrolysierbaren Rest bevorzugt sind.

Beispiele für weitere geeignete Oberflächenmodifikatoren sind quaternäre Ammoniumsalze der Formel NR¹R²R³R^{4 +} X⁻, worin R¹ bis R⁴ gegebenenfalls voneinander verschiedene aliphatische, aromatische oder cycloaliphatische Gruppen mit vorzugsweise 1 bis 12, insbesondere 1 bis 8 Kohlenstoffatomen darstellen, wie z.B. Alkylgruppen mit 1 bis 12, insbesondere 1 bis 8 und besonders bevorzugt 1 bis 6 Kohlenstoffatomen (z.B. Methyl, Ethyl, n- und i-Propyl, Butyl oder Hexyl), und X⁻ für ein anorganisches oder organisches Anion steht, z.B. Acetat, OH⁻, Cl⁻, Br⁻ oder I⁻.

Die Kohlenstoffketten dieser Verbindungen können durch O-, S-, oder NH-Gruppen unterbrochen sein. Derartige Oberflächenmodifizierungsmittel sind z.B. Oxaalkansäuren, wobei 1, 2, 3 oder mehr Oxagruppen enthalten sein können. Beispiele sind Trioxadecansäure, 3-Oxabutansäure, 2,6-Dioxaheptansäure und deren Homologe.

Für die im Rahmen der Erfindung besonders bevorzugten TiO₂-Partikel ist eine Oberflächenmodifikation mit einer α-Hydroxycarbonsäure, α-Ketocarbonsäure oder β-Hydroxycarbonsäure oder einem Derivat davon bevorzugt, ganz besonders bevorzugt ist eine Oberflächenmodifikation mit Salicylsäure oder Acetylsalicylsäure.

Bevorzugt wird die Oberflächenmodifikation der Partikel eingesetzt, um eine Emulsion zu stabilisieren. Durch die Oberflächenmodifikation lässt sich der Kontaktwinkel der Partikel zu den jeweiligen Phasen der Emulsion einstellen. Dadurch können die Partikel für eine bestimmte Emulsion optimiert werden.

Dies bestimmt auch die Anzahl der gebundenen Moleküle zur Oberflächenmodifikation. In einer weiteren Ausführungsform sind die Titandioxid-Partikel mit unter 10 Molekülen/nm² oberflächenmodifiziert, bevorzugt mit unter 5 Molekülen/nm² (gemessen mit Simultaner Thermoanalyse bevorzugt gemessen mit Netzsch STA 449 C Jupiter)

In einer Ausführungsform der Erfindung handelt es sich bei der Initiatorzusammensetzung um eine Dispersion von Nanopartikeln, welche auch oberflächenmodifiziert sein können, in mindestens einem Lösungsmittel. Der Anteil der Nanopartikel beträgt dabei unter 20 Gew.-%, bevorzugt unter 10 Gew.-%, besonders bevorzugt unter 5 Gew.-%. Ein bevorzugter Bereich liegt zwischen 0,5 Gew.-% und 3 Gew.-%. Beispiele sind 1 Gew.-%, 1,5 Gew.-%, 2 Gew.-% und 2,5 Gew.-%. Dabei bezieht sich der Anteil auf die gesamte Initiatorzusammensetzung.

In einer bevorzugten Ausführungsform der Erfindung ist die Initiatorzusammensetzung eine Emulsion. Bevorzugt handelt es sich um eine Emulsion mit einem Gehalt zwischen 15 Gew.-% und 40 Gew.-% an Ölphase, bevorzugt einem Gehalt zwischen 20 Gew.-% und 30 Gew.-%.

In einer bevorzugten Ausführungsform der Erfindung umfasst die Initiatorzusammensetzung eine Pickering-Emulsion, d.h. eine Emulsion, welche durch Nanopartikel stabilisiert wird. Bevorzugt sind dabei die Nanopartikel die aktive Substanz der Initiatorzusammensetzung. Der Gehalt an Nanopartikeln liegt dabei über 0,1 Gew.-% bezogen auf die gesamte Initiatorzusammensetzung.

In einer bevorzugten Ausführungsform wird die Pickering-Emulsion in mehreren Schritten hergestellt. Zunächst wird eine wässrige Dispersion von Nanopartikeln mit einem, nicht mit Wasser mischbaren, Lösungsmittel gemischt und anschließend zu einer Emulsion dispergiert. Bevorzugt liegt dabei der Gehalt an Nanopartikeln über 0,1 Gew.-%, bevorzugt über 0,2 Gew.-%, bezogen auf die gesamte Emulsion. Bevorzugt liegt der Gehalt an Nanopartikeln zwischen 0,1 Gew.-% und 5 Gew.-%, besonders bevorzugt zwischen 0,1 Gew.-% und 2 Gew.-%, ganz besonders bevorzugt zwischen 0,2 Gew.-% und 1,5 Gew.-%, bzw. 1 Gew.-%. Da erst in einem weiteren Schritt die leitfähige Metallschicht aufgebracht wird, kann mit deutlich geringeren Gehalten an Partikeln gearbeitet werden, als wenn direkt metallische Partikel verwendet werden.

Insbesondere bei oberflächenmodifizierten Partikeln kann es nach einer Standzeit zu einer Aufrahmung der Emulsion kommen. Dabei bildet sich durch die Aufrahmung eine obere aufkonzentrierte Emulsionsphase. Falls eine solche Aufrahmung beobachtet wird, wird die untere, im Wesentlichen, wässrige Phase separiert und die obere aufkonzentrierte Emulsionsphase als Initiatorzusammensetzung verwendet. In dieser aufkonzentrierten Emulsionsphase kann der Gehalt an Partikeln höher sein. In diesem Fall beziehen sich die vorstehenden Angaben auf die gesamte Zusammensetzung vor der Aufrahmung. Die Standzeit zur Aufrahmung der Emulsion beträgt bevorzugt 1 bis 30 Minuten.

Es kann zusätzlich erforderlich sein, die hergestellten Emulsionen zunächst eine bestimmte Zeit stehen zu lassen, beispielsweise zwischen 1 h und 72 h.

Durch das Verhältnis der beiden Phasen und die Oberflächenmodifikation der Partikel kann die Größe der in der Emulsion vorhandenen Tröpfchen, im Falle einer O/W-Emulsion der Öltröpfchen, eingestellt werden. Da diese die spätere Dichte des Netzwerks bestimmen, stellen sie einen wichtigen Parameter dar, falls transparente Strukturen erhalten werden sollen.

In einer bevorzugten Ausführungsform der Erfindung liegt die durchschnittliche Tröpfchengröße der Emulsion nach Aufbringen auf das Substrat zwischen 1 µm und 500 µm (lichtmikroskopisch bestimmt). Im Falle von transparenten Strukturen liegt die durchschnittliche Tröpfchengröße bevorzugt zwischen 30 µm und 400 µm. Dabei werden nur sphärische Tröpfchen berücksichtigt.

Die Tröpfchengröße in Lösung kann sich mit dem Alter der Emulsion verändern. In Abhängigkeit von der Grenzflächenspannung kommt es in Emulsionen zur Koaleszenz, was zu größeren Tröpfchen führt.

Zum Aufbringen der Initiatorzusammensetzung können übliche Verfahren verwendet werden, beispielsweise Tauchen, Rollen, Rakeln, Fluten, Ziehen, Spritzen, Schleudern oder Aufstreichen. Das Aufbringen kann vollständig oder partiell erfolgen.

Die aufgebrachte Dispersion wird getrocknet. Die dafür verwendete Temperatur hängt vom Substrat ab. Bei Kunststoffsubstraten oder Kunststoffoberflächen, können naturgemäß keine sehr hohen Temperaturen verwendet werden. Bevorzugt wird die Trocknung bei unter 200 °C durchgeführt, bevorzugt bei unter 150 °C. Besonders bevorzugt bei unter 100 °C. Die Behandlung mit der für die Trocknung verwendeten Temperatur erfolgt bevorzugt für zwischen 2 Minuten und 120 Stunden.

Wichtig für die erfindungsgemäße Methode ist, dass bei der Trocknung kein Sintern stattfinden muss, da die metallische Schicht erst im nächsten Schritt aufgetragen wird. Es ist daher möglich, auch bei Temperaturen von unter 40 °C, bzw. unter 30 °C Strukturen zu trocknen. Bei diesen Temperaturen ist eine Trocknungszeit von 1 Stunde bis 36 Stunden bevorzugt.

Die Trocknung kann mit oder ohne eine Abdeckung geschehen. Die Abdeckung kann eine Glas- oder Kunststoffplatte, eine Folie oder ein poröses Filtertuch sein. Durch eine Abdeckung kann die Selbstorganisation der Emulsion auf der Oberfläche beeinflusst werden.

Wie bereits vorstehend erwähnt kann sich das Trocknen auch auf die Größenverteilung der dispersen Phase der Emulsion auswirken.

Gerade bei der Verwendung von Pickering-Emulsionen mit oberflächenmodifizierten Partikeln kann die Zeit zur Trocknung auf unter 2 Stunden, bevorzugt unter 1 Stunde reduziert werden, bevorzugt bei Temperaturen zwischen 20 °C und 120 °C. Es ist sogar möglich, die Trocknung auf unter 10 Minuten, bevorzugt unter 6 Minuten, besonders bevorzugt unter 4 Minuten zu reduzieren, bevorzugt bei Temperaturen zwischen 50 °C und 120 °C. Solche Emulsionen bilden auf der Oberfläche auch bei sehr kurzer Trocknung eine stabile netzartige Struktur aus. Dadurch ist auch die Beschichtung von Substraten möglich, welche nur für einen kurzen Zeitraum solchen Temperaturen ausgesetzt werden dürfen.

Es kann notwendig sein, die Proben vor dem Auftragen der nächsten Zusammensetzung zu waschen und erneut zu trocknen.

In einem nächsten Schritt wird eine Vorläuferzusammensetzung umfassend mindestens eine Vorläuferverbindung für eine Metallschicht auf das Substrat aufgetragen.

Üblicherweise ist die Vorläuferzusammensetzung eine Lösung oder Suspension der mindestens einen Vorläuferverbindung. Diese Lösung kann auch ein Gemisch aus mehreren Vorläuferverbindungen enthalten. Auch können weitere Hilfsstoffe, wie Reduktionsmittel oder Benetzungshilfsmittel in der Lösung enthalten sein.

Bei der Vorläuferverbindung handelt es sich bevorzugt um einen Metallkomplex. Dieser umfasst mindestens ein Metallion oder ein Metallatom und mindestens eine Art von Liganden. Bei dem Metall handelt es sich beispielsweise um Silber oder Gold. In einer bevorzugten Ausführungsform ist die Vorläuferverbindung ein Silber-, Goldkomplex, besonders bevorzugt ein Silberkomplex. Die Vorläuferverbindung kann auch mehrere Arten von Metall oder Mischungen von Metallkomplexen umfassen.

Als Ligand werden in der Regel Chelatliganden eingesetzt. Diese sind in der Lage besonders stabile Komplexe zu bilden. Dabei handelt es sich um Verbindungen, welche mehrere Hydroxylgruppen und/oder Aminogruppen aufweisen. Bevorzugt sind Verbindungen mit einem Molekulargewicht von unter 200 g/mol, besonders bevorzugt Verbindungen mit mindestens einer Hydroxylgruppe und mindestens einer Aminogruppe. Beispiele für mögliche Verbindungen sind 3-Amino-1,2-propandiol, 2-Amino-1-butanol, Tris(hydroxymethyl)-aminomethan (TRIS), NH₃, Nikotinamid oder 6-Aminohexansäure. Es können auch Mischungen dieser Liganden verwendet werden. Im Falle des bevorzugten Silberkomplexes ist als Ligand TRIS bevorzugt.

Die Vorläuferzusammensetzung kann zusätzlich noch weitere Hilfsmittel, wie Tenside oder unterstützende Reduktionsmittel enthalten.

Die Vorläuferzusammensetzung kann auf beliebige Weise auf das Substrat aufgetragen werden. Dabei wird die Vorläuferzusammensetzung so aufgetragen, dass durch die aktive Substanz der Initiatorschicht direkt oder indirekt die Reduktion des Metallions zum Metall ausgelöst werden kann. Üblicherweise geschieht dies dadurch, dass die Vorläuferzusammensetzung direkt auf die Initiatorschicht aufgetragen wird.

Zum Aufbringen der Vorläuferzusammensetzung können übliche Verfahren verwendet werden, beispielsweise Tauchen, Rollen, Rakeln, Fluten, Ziehen, Spritzen, Schleudern oder Aufstreichen. Das Aufbringen kann vollständig oder partiell erfolgen.

In einer weiteren Ausführungsform der Erfindung ist die Vorläuferzusammensetzung eine Emulsion. Dadurch kann auch die Metallverbindung in einer bestimmten Struktur auf das Substrat aufgebracht werden.

Besonders bevorzugt sind Emulsionen mit einem Gehalt zwischen 15 Gew.-% und 48 Gew.-% an Ölphase bezogen auf die gesamte Zuammensetzung, bevorzugt zwischen 30 Gew.-% und 45 Gew.-% im Falle eine O/W-Emulsion und zwischen 60 Gew.-% und 80 Gew.-% im Falle einer W/O-Emulsion. Die Emulsion kann noch weitere Dispergiermittel oder Emulgatoren enthalten.

In einem nächsten Schritt wird das Metallion der Vorläuferverbindung durch die Initiatorverbindung zum Metall reduziert. Die Art der Aktivierung der Reduktion hängt von der verwendeten Initiatorverbindung ab. Es kann sich um eine thermische, chemische oder photochemische Aktivierung handeln.

Aufgrund der Strukturierung von mindestens einer der aufgetragenen Zusammensetzungen, wird nur in den Bereichen Metall abgeschieden, in die Vorläuferverbindung und die aktive Substanz der Initiatorzusammensetzung auf der Oberfläche übereinander angeordnet sind.

Wenn die Initiatorzusammensetzung als Emulsion aufgetragen wurde, so wird nur dort Metall abgeschieden, wo sich die Phase mit der aktiven Substanz der Emulsion befunden hat. Bei den bevorzugten Pickering-Emulsionen der aktiven Substanz wird nur um die durch die Nanopartikel stabilisierten Tröpfchen herum Metall abgeschieden.

Erfindungsgemäß ist eine photochemische Aktivierung. Dabei wird durch Einwirkung von elektromagnetischer Strahlung auf den Initiator zum Metall reduziert. Dabei bildet sich eine metallische Schicht. Bei der elektromagnetischen Strahlung handelt es sich um Strahlung der Wellenlänge zur Anregung des Initiators. Dabei kann die Bestrahlung durch Verwendung einer flächigen Strahlungsquelle, wie einer Lampe, oder durch Laser geschehen. Bevorzugt wird eine Wellenlänge im sichtbaren oder ultravioletten Bereich des elektromagnetischen Spektrums verwendet, bevorzugt Strahlung mit einer Wellenlänge von < 500 nm, beispielsweise zwischen 200 nm und 450 nm oder zwischen 210 nm und 410 nm. Bevorzugt ist es Strahlung mit einer Wellenlänge von < 400 nm.

Als Lichtquelle kann jede geeignete Lichtquelle verwendet werden. Beispiele für eine Lichtquelle sind Quecksilberdampflampen oder Xenonlampen.

Die Lichtquelle ist in geeignetem Abstand zu dem zu belichtenden Substrat angeordnet. Der Abstand kann dabei beispielsweise zwischen 2,5 cm und 50 cm betragen. Die Intensität der Strahlung kann dabei in einem Spektralbereich von 250 nm bis 410 nm zwischen 1 mW/cm² und 400 mW/cm² liegen.

Die Bestrahlung sollte möglichst senkrecht zur zu belichtenden Oberfläche erfolgen.

Die Bestrahlung wird in der zur Bildung der metallischen Schicht ausreichenden Dauer durchgeführt. Die Dauer hängt dabei von der Beschichtung, der Art des Initiators, der Art der Lampe, des verwendeten Wellenlängenbereichs und der Intensität der Bestrahlung ab. Falls leitfähige Strukturen erzeugt werden sollen, kann eine längere Bestrahlung erforderlich sein. Bevorzugt ist eine Dauer der Bestrahlung zwischen 5 Sekunden und 10 Minuten, bevorzugt zwischen 20 Sekunden und 4 Minuten.

Falls zur Bestrahlung ein Laser verwendet wird, kann beispielsweise ein Argon-Ionen-Laser (351 nm) mit 10 mW eingesetzt werden, dessen Laserstrahl fokussiert und kollimiert und mit einer Geschwindigkeit von 2 mm/s über das zu bestrahlende Substrat geführt wird.

In einer weiteren Ausführungsform der Erfindung wird das Substrat nach der Bestrahlung und Reduktion der Vorläuferverbindung weiter behandelt. So kann beispielsweise die nicht reduzierte überschüssige Vorläuferzusammensetzung durch Spülen der Oberfläche entfernt werden, beispielsweise mit deionisiertem Wasser oder einer anderen geeigneten Substanz. Das beschichtete Substrat kann danach getrocknet werden, beispielsweise durch Erwärmen in einem Ofen, Druckluft und/oder durch Trocknen bei Raumtemperatur.

Es können auch noch weitere Schichten, beispielsweise zum Schutz der beschichteten Oberfläche vor Oxidation und Wasser oder vor UV-Strahlung aufgebracht werden.

In einer Ausführungsform der Erfindung erfolgt beim Auftragen der Vorläuferzusammensetzung und/oder bei der Reduktion zusätzlich eine Strukturierung. Darunter wird im Sinne der Erfindung eine Vorbereitung der räumlich begrenzten Erzeugung der metallischen Struktur verstanden. Dies ist auf unterschiedliche Weise möglich. Zum einen kann das Substrat nur in bestimmten Bereichen mit der Initiatorzusammensetzung beschichtet werden. Außerdem ist es möglich, die Vorläuferzusammensetzung nur auf bestimmte Bereiche aufzubringen. Desweiteren kann natürlich auch die Einwirkung der elektromagnetischen Strahlung auf bestimmte Bereiche begrenzt werden. Diese Verfahren können natürlich auch in Kombination verwendet werden.

In einer bevorzugten Weiterbildung der Erfindung umfasst die Vorbehandlung eine Plasmabehandlung, Koronabehandlung, Flammenbehandlung und/oder das Auftragen und Härten einer organischanorganischen Beschichtung. Eine Plasmabehandlung, Koronabehandlung und/oder Flammenbehandlung kommt insbesondere bei Foliensubstraten, insbesondere bei Kunststofffolien in Betracht. Dabei wurde gefunden, dass eine solche Behandlung die Qualität der erhaltenen photokatalytischen Schicht verbessert.

Mögliche Wege zum Erhalt von Plasma unter Vakuumbedingungen sind in der Literatur häufig beschrieben worden. Die elektrische Energie kann durch induktive oder kapazitive Mittel verknüpft werden. Sie kann Gleichstrom oder Wechselstrom sein; die Frequenz des Wechselstroms kann von einigen kHz bis in den MHz-Bereich reichen. Eine Energiezufuhr im Mikrowellenbereich (GHz) ist auch möglich.

Als primäre Plasmagase können beispielsweise He, Argon, Xenon, N₂, O₂, H₂, Dampf oder Luft, und ebenso Gemische aus diesen Verbindungen verwendet werden. Bevorzugt ist ein Sauerstoffplasma.

Üblicherweise werden die Substrate vorher gesäubert. Dies kann durch einfaches Abspülen mit einem Lösungsmittel geschehen. Die Substrate werden danach gegebenenfalls getrocknet und dann für unter 5 Minuten mit Plasma behandelt. Die Behandlungsdauer kann von der Empfindlichkeit des Substrats abhängen. Üblicherweise beträgt sie zwischen 1 und 4 Minuten.

Eine weitere Möglichkeit die Qualität der photokatalytischen Schicht zu verbessern, ist die vorherige Flammenbehandlung der Oberfläche. Eine solche Behandlung ist dem Fachmann bekannt. Die auszuwählenden Parameter werden durch das bestimmte zu behandelnde Substrat vorgegeben. Beispielsweise werden die Flammentemperaturen, die Flammenintensität, die Verweilzeiten, der Abstand zwischen Substrat und Flamme, das Wesen des Verbrennungsgases, Luftdruck, Feuchtigkeit, auf das in Frage stehende Substrat abgestimmt. Als Flammengase können beispielsweise Methan, Propan, Butan oder ein Gemisch aus 70 % Butan und 30 % Propan verwendet werden. Auch diese Behandlung findet bevorzugt bei Folien, besonders bevorzugt bei Kunststofffolien Anwendung.

Es kann erforderlich sein, die erhaltenen metallischen Strukturen durch eine zusätzliche Wärmebehandlung zu sintern. Bevorzugt ist allerdings keine zusätzliche Wärmebehandlung durchzuführen.

In einer bevorzugten Ausführungsform der Erfindung enthält das Verfahren keine Wärmebehandlung bei über 100 °C. Mit dem erfindungsgemäßen Verfahren ist es sogar möglich, nur bei Temperaturen von unter 50 °C, bzw. unter 40 °C zu arbeiten.

Der Vorteil des erfindungsgemäßen Verfahrens liegt insbesondere darin, dass durch das nachträgliche Abscheiden des Metalls die Menge des abgeschiedenen Metalls und damit die Leitfähigkeit der Strukturen deutlich besser gesteuert werden kann. Wenn direkt metallische Partikel verwendet werden, muss mit einem hohen Gehalt an Partikeln gearbeitet werden. Gleichzeitig ist ein Sintern der Strukturen erforderlich, um die Partikel miteinander zu verschmelzen. Dies kann mit dem erfindungsgemäßen Verfahren verhindert werden.

Außerdem kann gerade wenn die Initiatorzusammensetzung als Emulsion aufgebracht wird, insbesondere als Pickering-Emulsion mit Nanopartikeln als aktiver Substanz, mit einem geringen Gehalt an Nanopartikeln gearbeitet werden.

Bei dem erfindungsgemäßen Verfahren werden insbesondere zwischen dem Auftragen der Initiatorzusammensetzung und dem Auftragen der Vorläuferzusammensetzung und der daran anschließenden Metallisierung keine weiteren Zusammensetzungen auf das Substrat aufgetragen. Aufgrund der selektiven Abscheidung ist auch keine Versiegelung der nicht mit der aktiven Substanz beschichteten Bereiche des Substrats vor dem Aufbringen der Vorläuferzusammensetzungen notwendig.

Durch das erfindungsgemäße Verfahren können elektrisch leitfähige Beschichtungen, erhalten werden. Besonders bevorzugt sind transparente leitfähige Beschichtungen.

Die erhaltenen transparenten und leitfähigen Beschichtungen können beispielsweise als transparente Elektroden für Displays, Bildschirme und Touchpanels verwendet werden.

Weitere Einzelheiten und Merkmale ergeben sich aus der nachfolgenden Beschreibung von bevorzugten Ausführungsbeispielen in Verbindung mit den Unteransprüchen. Hierbei können die jeweiligen Merkmale für sich alleine oder zu mehreren in Kombination miteinander verwirklicht sein. Die Möglichkeiten, die Aufgabe zu lösen, sind nicht auf die Ausführungsbeispiele beschränkt. So umfassen beispielsweise Bereichsangaben stets alle - nicht genannten - Zwischenwerte und alle denkbaren Teilintervalle.

Die Ausführungsbeispiele sind in den Figuren schematisch dargestellt. Gleiche Bezugsziffern in den einzelnen Figuren bezeichnen dabei gleiche oder funktionsgleiche bzw. hinsichtlich ihrer Funktionen einander entsprechende Elemente. Im Einzelnen zeigt:
- Fig. 1: a) Schematische Darstellung des erfindungsgemäßen Verfahrens; b) schematische Darstellung des erhaltenen Netzwerks;
- Fig. 2: Lichtmikroskopische Aufnahme der Emulsion 7h auf einem Substrat unter einem Deckglas (20 °C);
- Fig. 3: Lichtmikroskopische Aufnahme der Emulsion 7k auf einem Substrat unter einem Deckglas (20 °C);
- Fig. 4: Lichtmikroskopische Aufnahme einer Titandioxid-Nanopartikel-Emulsion (Probe 7h) vor der Metallisierung. Der Maßstab ist 10 µm;
- Fig. 5: Lichtmikroskopische Aufnahme einer Titandioxid-Nanopartikel-Emulsion (Probe 7h) nach der Metallisierung. Der Maßstab ist 10 µm;
- Fig. 6: Lichtmikroskopische Aufnahmen von Emulsionen; a) Emulsion 8a direkt nach dem Auftragen; b) die gleiche Emulsion 15 Minuten später; c) Emulsion 8g nach dem Auftragen; d) die gleiche Emulsion 15 Minuten später;
- Fig. 7: Lichtmikroskopische Aufnahme der eingetrockneten Emulsion (8a) bei 90 °C mit Auflicht; Graue Bereiche sind unbeschichtet;
- Fig. 8: Ausschnitt aus Figur 7;
- Fig. 9: Lichtmikroskopische Aufnahme der versilberten Emulsion (8a) mit Auflicht;
- Fig. 10: DLS-Messungen einer Dispersion mit 2 Gew.-% TiO₂ bei 20 °C;
- Fig. 11: DLS-Messungen einer verdünnten Lösung von mit Acetylsalicylsäure modifizierten TiO₂-Partikeln bei 20°C;
- Fig. 12: DLS-Messungen einer verdünnten Lösung von mit Salicylsäure modifizierten TiO₂-Partikeln bei 20°C.

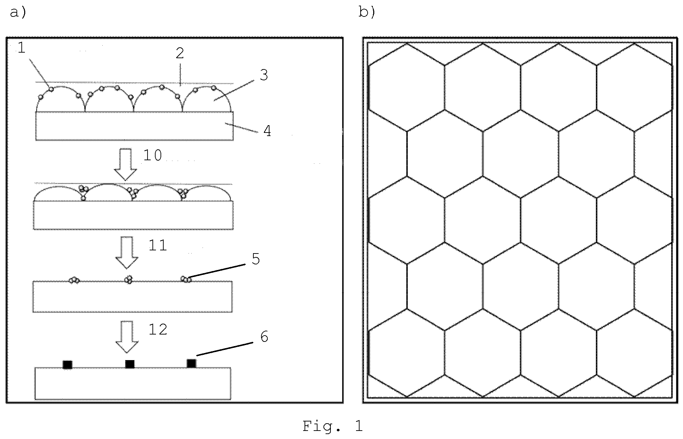

Figur 1a zeigt eine schematische Darstellung einer bevorzugten Ausführungsform des Verfahrens. Zunächst wird eine Emulsion einer Initiatorzusammensetzung umfassend zwei Phasen 2, 3, welche Nanopartikel 1 enthält, auf ein Substrat 4 aufgetragen. Es handelt sich bevorzugt um einer Pickering-Emulsion, welche durch die Nanopartikel 1 stabilisiert wird. Die aufgetragene Emulsion wird auf der Oberfläche des Substrats getrocknet (Schritt 10). Dabei kommt es zur Konzentration der Nanopartikel an den Phasengrenzflächen der Emulsion auf der Oberfläche (Schritt 11). Dadurch bilden sich dünne netzartige Strukturen aus den Nanopartikeln 5. Danach (Schritt 12) wird an den Nanopartikeln ein Metall 6 abgeschieden. Man erhält eine netzartige metallisierte Struktur. Eine idealisierte Darstellung der erhaltenen Struktur zeigt Figur 1b.

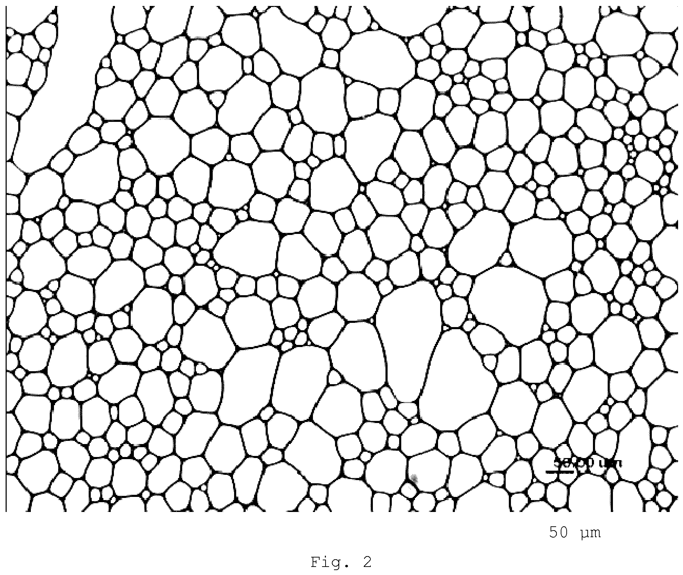

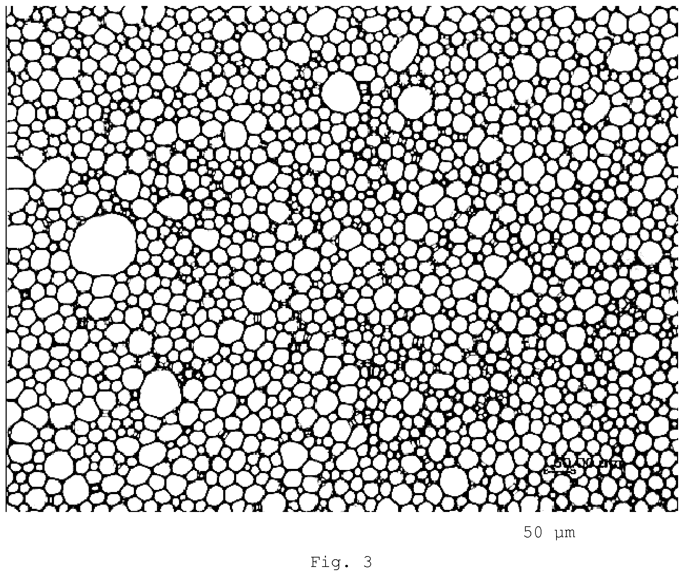

Figur 2 zeigt eine lichtmikroskopische Aufnahme einer Emulsion mit unmodifizierten Titandioxidpartikeln. Die Emulsion zeigt auf dem Substrat eine Tröpfchengröße zwischen 30 und 140 µm. Figur 3 zeigt den Einfluss der Zugabe von Butanol als schwacher Emulgator. Es führt zu einer deutlichen Reduktion der Tröpfchengröße.

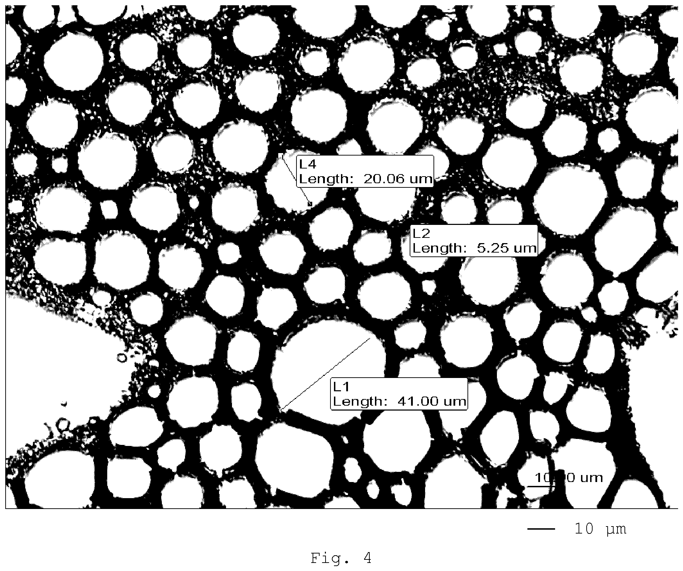

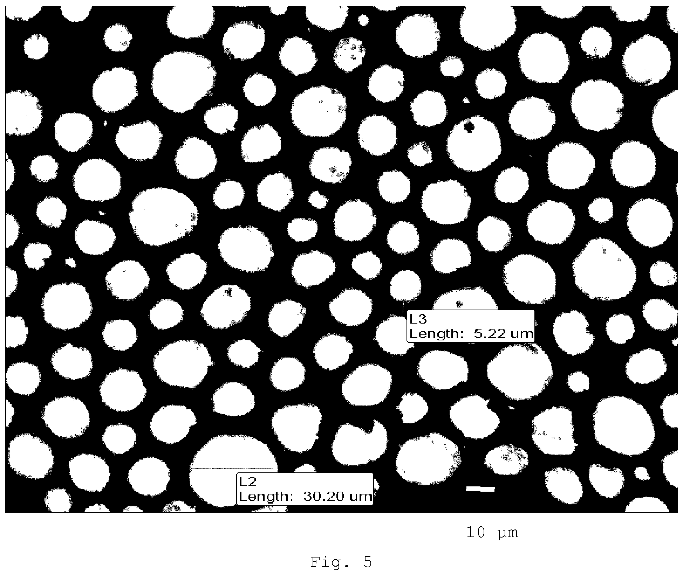

Figur 4 zeigt eine Emulsion mit unmodifizierten Titandioxid-Partikeln nach dem Trocknen, welche in Figur 5 im nächsten Schritt mit Silber metallisiert wurde. Die Aufnahmen zeigen, dass die Metallabscheidung sehr selektiv nur an dem Titandioxid stattfindet. Allerdings ist die Größe der Tröpfchen relativ gering, so dass die Probe nach der Metallisierung nicht transparent erscheint.

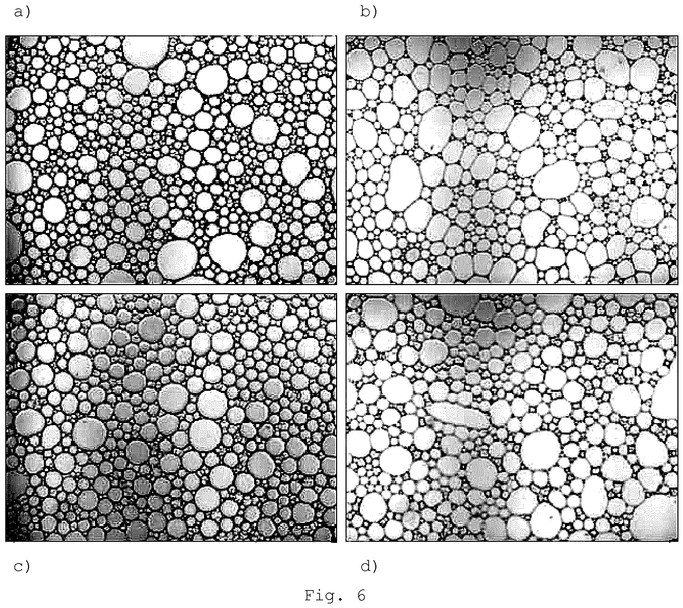

Figur 6 zeigt die Alterung von Emulsionen bei Raumtemperatur von zwei Emulsionen mit oberflächenmodifizierten Partikeln. Es ist deutlich zu erkennen, dass sich größere Tröpfchen aus der Oberfläche ausbilden. Dabei bildet sich eine Monolage größerer Tropfen aus. Nach zehn Minuten ist keine Dynamik mehr zu beobachten und die Lösungsmittel verdunsten langsam.

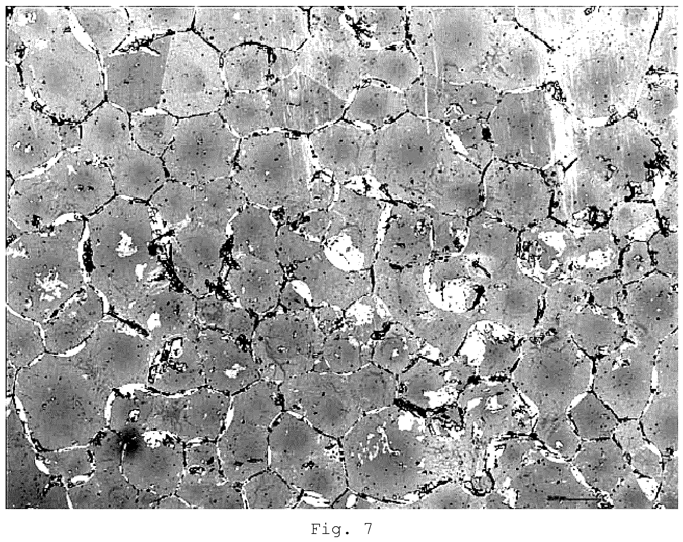

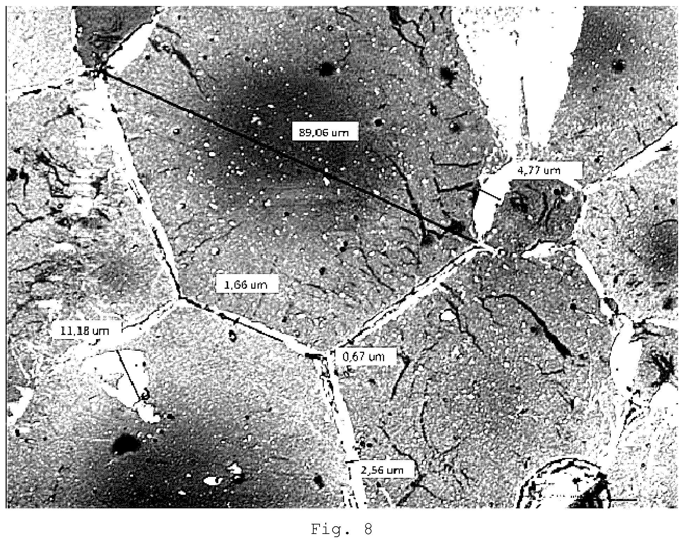

Die Figuren 7 und 8 zeigen eine getrocknete Emulsion mit oberflächenmodifizierten Titandioxidpartikeln. Es sind deutlich die ausgebildeten Stege aus Titandioxid zu erkennen, welche ein wabenähnliches Muster ausbilden.

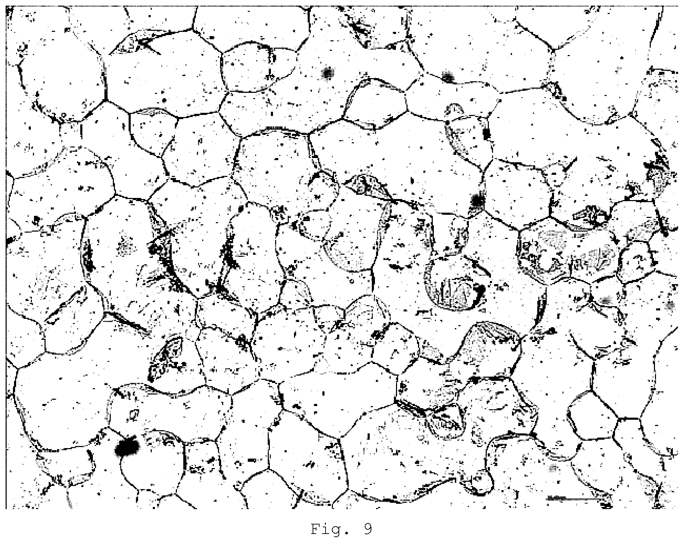

Diese Struktur kann wie in Figur 9 gezeigt auf einfache Weise mit Silber metallisiert werden.

### Ausführungsbeispiele:

Für Transmissionselektronenmikroskopie (TEM) wurde ein Philips CM200 FEG (200kV Beschleunigungsspannung) verwendet.

Die Lichtmikroskopischen Aufnahmen wurden mit einem Olympus BH2 Series System Microscope mit Durchlicht oder Auflicht aufgenommen.

Dynamische Lichtstreuung (DLS) zur Messung des hydrodynamischen Radius wurde mit einem Microtrac Nanotrac Ultra durchgeführt.

### 1. Synthese von TiO₂-Nanopartikeln (Anatas)

In einem 250 mL Rundkolben werden 97,07 g (342 mmol) Titanisopropoxid in 105,45 g (1745 mmol) 1-Propanol vorgelegt und intensiv gerührt. Es werden 6,69 g (68 mmol) 37%ige Salzsäure in 20,00 g (333 mmol) 1-Propanol gegeben und diese Lösung nach zwei Minuten langsam der Reaktionsmischung zugetropft. Nach 30 Minuten wird ein Gemisch aus 8,05 g (447 mmol) Wasser und 40,00 g (666 mmol) 1-Propanol tropfenweise zugegeben.

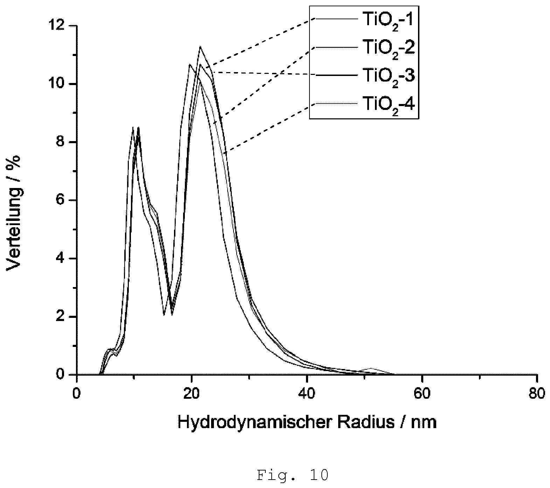

Der Ansatz wird für weitere 20 Minuten gerührt und das so entstandene Sol zu gleichen Teilen in zwei Teflonbehälter gegeben und im Autoklaven innerhalb von 30 Minuten auf 225 °C gebracht und für 120 Minuten auf dieser Temperatur gehalten.
Nach Abkühlung wird das Lösemittel abdekantiert und verworfen, der Bodensatz wird am Rotationsverdampfer bei maximal 40 °C fast vollständig eingetrocknet. Die Anatas-Nanopartikel werden als weißes Pulver erhalten. Figur 10 zeigt die Größenverteilung gemessen mit DLS.

Charakterisierung: BET: 11,14 nm; DLS: 1. Maximum: 10,52 nm (S=0,31), 2. Maximum: 21,04 nm (S=0,77); Raman: E_{G}: 146 cm⁻¹, B_{1G}: 399 cm⁻¹, A_{1G}: 639 cm⁻¹, E_{G}: 639 cm⁻¹.

### 2. Oberflächenmodifikation mit Acetylsalicylsäure (ASA)

Es werden 0,18 g Acetylsalicylsäure (1 mmol) in 45 g Wasser suspendiert und die erhaltene Suspension wird filtriert, um überschüssige Acetylsalicylsäure von der gesättigten Lösung abzutrennen.

Unter starkem Rühren wird eine Dispersion aus 10 g Wasser mit 2,50 g (31 mmol) Titandioxid-Partikeln (Anatas) sehr langsam tropfenweise zugegeben. Das Gemisch wird für weitere zehn Minuten intensiv durchmischt. Durch Zugabe von 7,03 g (71 mmol) 37%ige Salzsäure wird Essigsäure aus Acetylsalicylsäure eliminiert und die Reaktionsmischung färbt sich intensiv gelb. Die erhaltenen Partikel werden zentrifugiert, der Überstand abdekantiert und verworfen. Der Rückstand wird in 40,00 g Wasser redispergiert. Es resultiert eine klare, gelbe Dispersion.

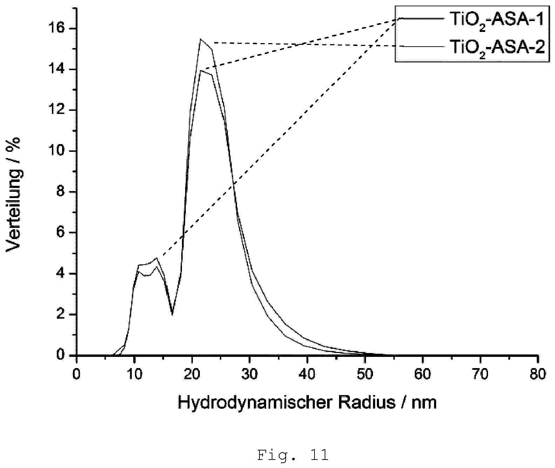

Figur 11 zeigt DLS Messungen von mehreren Proben, welche nach dem gleichen Verfahren hergestellt wurden. Es wurde die verdünnte erhaltene Dispersion vermessen.

### 3. Oberflächenmodifikation mit Salizylsäure (SA)

Es werden 0,14 g (1 mmol) Salizylsäure in 40 g Wasser suspendiert und die überschüssige Salizylsäure durch Filtration abgetrennt.

Unter starkem Rühren wird eine Dispersion aus 20 g Wasser und 3,58 g (44 mmol) Titandioxid langsam zugetropft. Das Gemisch wird für weitere 30 Minuten intensiv gerührt. Es wird eine leicht trübe, gelbe Dispersion erhalten.

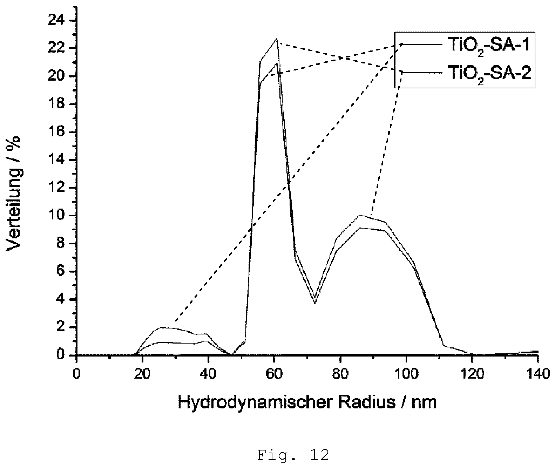

Figur 12 zeigt DLS Messungen von mehreren Proben, welche nach dem gleichen Verfahren hergestellt wurden. Es wurde die verdünnte erhaltene Dispersion vermessen.

### 4. Herstellung von Titandioxid-Pickering-Emulsionen

In einer 250 mL Flasche werden nach Tabelle E1 verschiedene Emulsionen dargestellt, welche sich in den Verhältnissen an Toluol, Wasser, Butanol und Titandioxidnanopartikel unterscheiden. Es werden grundsätzlich Wasser und Titandioxidnanopartikel vorgelegt und anschließend mit einem IKA® T25 Ultra Turrax® bei 25.000 rpm für zwei Minuten homogenisiert. Anschließend werden die organischen Lösemittel zugegeben und die Mischung unter Kühlung für weitere drei Minuten bei 25.000 rpm homogenisiert.

**Tabelle E1: Toluol/Wasser-Emulsionen mit TiO₂-Nanopartikeln (unmodifiziert)**

| Emulsion | Wasser [g] | Toluol [g] | Butanol [g] | TiO₂ [g] |
|---|---|---|---|---|
| 7a | 100,04 | 87,03 | - | 1,0 |
| 7b | 100,03 | 86,79 | - | 1,5 |
| 7c | 99,97 | 86,80 | - | 2,0 |
| 7d | 75,04 | 130,15 | - | 1,0 |
| 7e | 74,89 | 130,24 | - | 1,5 |
| 7f | 75,01 | 130,12 | - | 2,0 |
| 7g | 150,03 | 52,02 | - | 1,0 |
| 7h | 150,07 | 52,06 | - | 1,5 |
| 7i | 150,12 | 52,07 | - | 2,0 |
| 7j | 150,10 | 51,96 | 5 | 1,5 |
| 7k | 149,97 | 51,97 | 10 | 1,5 |
| 7l | 150,03 | 52,04 | 15 | 1,5 |

Die Emulsionen mit Butanol als schwacher Emulgator zeigen eine deutlich reduzierte Tröpfchengröße. Aufgrund der freien OH-Gruppen auf der Oberfläche der verwendeten Titandioxid-Partikel stabilisieren diese bevorzugt O/W-Emulsionen. Erwartungsgemäß werden die W/O-Emulsionen 7d, 7e, 7f nicht durch diese Titandioxid-Partikel stabilisiert. In allen anderen Fällen bilden sich Emulsionen.

### 5. Herstellung von Titanidioxid-Pickering-Emulsionen mit oberflächenmodifizierten Partikeln

In einem 20 mL Glasgefäß werden verschiedene Emulsionen nach Tabelle E2 und E3 dargestellt. Es wird aus 0,06 g (1 mmol) Natriumchlorid und 10,00 g Wasser eine NaCl-Lösung angesetzt.

Es werden die Dispersionen aus Beispiel 2 (TiO₂ mit ASA) oder Beispiel 3 (TiO₂ mit SA) vorgelegt, und die NaCl-Lösung zugegeben. Nach der Zugabe der organischen Phase wird Salzsäure (37 %) zugesetzt und das Gemisch mit einem Vibrations-Mischer (Heidolph® Reax Control®) bei 25.000 rpm emulgiert. In den ersten Minuten kann es, unabhängig vom Lösemittel, zu Aufrahmung kommen. In diesem Fall wird als Emulsion die obere Phase nach der Aufrahmung verwendet und als Emulsion bezeichnet. Die Tabellen E2 und E3 zeigen die hergestellten Emulsionen.

**Tabelle E2: Emulsionen basierend auf Toluol**

| Bezeichnung | TiO₂ mit ASA [g] | TiO₂ mit SA [g] | Toluol [g] | Wasser [g] | HCl [g] | NaCl-Lösung [g] |
|---|---|---|---|---|---|---|
| 8a | 1,03 | - | 4,33 | 10,01 | 1,01 | 0,14 |
| 8b | 2,01 | - | 4,32 | 9,00 | 1,00 | 0,10 |
| 8c | 3,00 | - | 4,33 | 8,03 | 1,00 | 0,13 |
| 8d | - | 1,00 | 4,33 | 10,00 | 1,01 | 0,10 |
| 8e | - | 1, 98 | 4,28 | 9,00 | 1,00 | 0,10 |
| 8f | - | 3,01 | 4,28 | 7,98 | 0, 99 | 0,12 |

**Tabelle E3: Emulsionen basierend auf Cyclohexan**

| Bezeichnung | TiO₂ mit ASA [g] | TiO₂ mit SA [g] | Cyclohexan [g] | Wasser [g] | HCl [g] | NaCl-Lösung [g] |
|---|---|---|---|---|---|---|
| 8g | 1,02 | - | 4, 67 | 10,00 | 1,00 | 0,12 |
| 8h | 1,98 | - | 4, 67 | 9,00 | 1,00 | 0,14 |
| 8i | 3,00 | - | 4,66 | 7, 97 | 1,00 | 0,12 |
| 8j | - | 1,00 | 4, 67 | 10,00 | 1,01 | 0,13 |
| 8k | - | 1,99 | 4,65 | 9,04 | 1,00 | 0,11 |
| 8l | - | 2,99 | 4,68 | 8,06 | 0,99 | 0,12 |

### 6. Aufbringen der Initiatorzusammensetzung ohne Oberflächenmodifikation

Auf einen Glasobjektträger wurden 200 µL der Emulsion 7h gegeben. Die Proben werden auf drei unterschiedliche Arten präpariert: (1) sie werden mit einem zweiten Objektträger bedeckt; (2) sie werden ohne Bedeckung getrocknet; (3) sie werden mit einem Filtertuch bedeckt. Nach dem Trocknen wurden die Objektträger gründlich mit destilliertem Wasser gewaschen, um überschüssiges Titandioxid abzutrennen.

Figur 7 zeigt die Probe 7h nach der Trocknung bei 20 °C für 26 Stunden.

### 7. Aufbringen der Initiatorzusammensetzung mit Oberflächenmodifikation:

Es wurden je 200 µL der hergestellten Emulsionen 8a bis 8l auf Glasobjektträger aufgegeben und ohne Bedeckung getrocknet. Die Tabelle E4 zeigt die Bedingungen der Trocknung der Emulsionen. Anschließend wurde eventuell überschüssiges Titandioxid und Natriumchlorid von den Objektträgern mit destilliertem Wasser abgespült und die Proben mit Druckluft getrocknet.

**Tabelle E4:**

| Temperatur [°C] | Zeit [min] |
|---|---|
| 30 | 60 |
| 40 | 20 |
| 50 | 7 |
| 60 | 7 |
| 70 | 5 |
| 80 | 5 |
| 90 | 3 |
| 100 | 3 |

In allen Fällen wurde eine Selbstorganisation, d.h. die Ausbildung einer netzartigen Struktur beobachtet.

Die Figuren 7 und 8 zeigen lichtmikroskopische Aufnahmen der getrockneten Struktur der Emulsion 8a bei 90 °C und 3 Minuten.

Die oberflächenmodifizierten Partikel sind aufgrund ihrer Salizylsäure-Modifikation an der Grenzfläche der beiden Phasen der Emulsion lokalisiert. Sie ordnen sich im Laufe der Trocknung zwischen den Tropfen an und es entsteht das ein Netzwerk. Während die Breite der Titandioxidstege im Bereich von 1 µm bis 3 µm variiert, werden große, unbeschichtete Bereiche von 40 µm bis 90 µm Durchmesser erhalten. Die in den Abbildungen vor der Trocknung vorhandene kleineren Tröpfchen sind während der Trocknung durch Koaleszenz und Alterung der Emulsion verschwunden.

Einzig die wenigen erkennbaren Verbreiterungen der Stege lassen die Beschichtung auf den Objektträgern teilweise sichtbar werden. In Bereichen bei denen diese Fehlbeschichtungen nicht oder zumindest kaum vorhanden sind, wirkt die eingetrocknete Probe optisch transparent.

### 8. Herstellung einer Vorläuferzusammensetzung (Ag-TRIS)

Unter starkem Rühren wurde eine Lösung von 1,69 g (10 mmol) Silbernitrat in 20 g Wasser langsam in eine Lösung aus 2,57 g Tris-(hydroxymethyl)-aminomethan (9 mmol) in 20 g Wasser getropft.

### 9. Aufbringen der Vorläuferzusammensetzung

Die getrockneten Proben wurden mit Ag-TRIS geflutet und anschließend mit einer Hg-Xe-Lampe (1000 Watt) für 10 bis 30 Sekunden belichtet. Nur an den Titandioxid-Stegen wird Silber abgeschieden.

Figur 5 zeigt eine belichtete Probe (30 Sekunden; Hg-Xe-Lampe; 1000 Watt) einer Emulsion mit nicht oberflächenmodifizierten Titandioxidpartikeln. Es zeigt sich eine Verteilung von runden nicht versilberten Bereichen. Versilberte Stege sind ca. 6 µm breit. Daher ist die Probe zwar gleichmäßig selektiv metallisiert aber die Probe ist nicht transparent.

Figur 9 zeigt eine belichtete Probe (15 Sekunden Hg-Xe-Lampe; 1000 Watt) einer Emulsion mit oberflächenmodifizierten Titandioxidpartikeln. Auch diese Probe wurde nur in den mit Titandioxidpartikeln beschichteten Bereich versilbert. Die optische Transparenz ändert sich nicht, da die Stege deutlich dünner sind.

### Zitierte Literatur

WO 2012/084849 A2
US 2009/0269510 A1
WO 93/21127
DE 4212633
WO 96/31572

## Patentansprüche

1. Verfahren zur Herstellung von strukturierten metallischen Beschichtungen (6) umfassend die folgenden Schritte:
a) Auftragen einer Initiatorzusammensetzung (2,3)umfassend mindestens eine aktive Substanz auf einem Substrat, wobei die Zusammensetzung eine Emulsion ist und die aktive Substanz nanoskalige Partikel (1) aus ZnO oder TiO₂ ist;
b) Auftragen einer Vorläuferzusammensetzung umfassend mindestens eine Vorläuferverbindung für eine Metallschicht (6) auf das Substrat (4) und
c) Abscheidung einer Metallschicht (6) aus der Vorläuferzusammensetzung durch die aktive Substanz der Initiatorzusammensetzung durch photochemische Aktivierung;
wobei zwischen Schritt a) und Schritt b) eine Trocknung durchgeführt wird, was zu einer Konzentration der Nanopartikel an den Phasengrenzflächen der Emulsion auf der Oberfläche führt (5) .

2. Verfahren nach Anspruch 1, **dadurch gekennzeichnet, dass**
die Partikel oberflächenmodifiziert sind.

3. Verfahren nach einem der Ansprüche 1 oder 2, **dadurch gekennzeichnet, dass**
die Emulsion eine Pickering-Emulsion ist.

4. Verfahren nach einem der Ansprüche 1 bis 3, **dadurch gekennzeichnet, dass**
der Gehalt an Nanopartikeln in der Initiatorzusammensetzung über 0,1 Gew.-% liegt.

## Claims

1. Method for producing structured metallic coatings (6), comprising the following steps:
a) application of an initiator composition (2, 3) comprising at least one active substance to a substrate, where the composition is an emulsion and the active substance is nanoscale particles (1) of ZnO or TiO₂;
b) application of a precursor composition comprising at least one precursor compound for a metal layer (6) to the substrate (4) and
c) deposition of a metal layer (6) of the precursor composition by the active substance of the initiator composition by photochemical activation;
where a drying is carried out between step a) and step b), which leads to a concentration of the nanoparticles at the phase boundary surfaces of the emulsion on the surface (5).

2. Method according to Claim 1, **characterized in that** the particles are surface-modified.

3. Method according to one of Claims 1 to 2, **characterized in that** the emulsion is a Pickering emulsion.

4. Method according to one of Claims 1 to 3, **characterized in that** the content of nanoparticles in the initiator composition is more than 0.1% by weight.

## Revendications

1. Procédé pour la fabrication de revêtements métalliques structurés (6), comprenant les étapes suivantes :
a) application d'une composition initiatrice (2, 3) comprenant au moins une substance active sur un substrat, la composition étant une émulsion et la substance active étant des particules nanométriques (1) de ZnO ou de TiO₂ ;
b) application d'une composition de précurseur comprenant au moins un composé précurseur pour une couche métallique (6) sur le substrat (4) et
c) dépôt d'une couche métallique (6) à partir de la composition de précurseur par la substance active de la composition initiatrice par activation photochimique ;
un séchage étant effectué entre l'étape a) et l'étape b), ce qui conduit à une concentration des nanoparticules au niveau des interfaces des phases de l'émulsion sur la surface (5).

2. Procédé selon la revendication 1, **caractérisé en ce que** les particules sont modifiées en surface.

3. Procédé selon l'une quelconque des revendications 1 ou 2, **caractérisé en ce que** l'émulsion est une émulsion de Pickering.

4. Procédé selon l'une quelconque des revendications 1 à 3, **caractérisé en ce que** la teneur en nanoparticules dans la composition initiatrice est supérieure à 0,1% en poids.
